# EUROPEAN PATENT SPECIFICATION

(11) **EP 4 451 653 B1**
(45) Date of publication and mention of the grant of the patent: **04.03.2026**
(21) Application number: 22927483.2
(22) Date of filing: 20.12.2022
(51) Int. Cl.: H04M 1/02, H05K 5/00, H05K 5/02, H05K 9/00, H05K 7/02, H05K 1/14

(54) **ELECTRONIC DEVICE COMPRISING SUPPORT BODY AT WHICH COAXIAL CABLE IS POSITIONED**
ELEKTRONISCHE VORRICHTUNG MIT EINEM TRÄGERKÖRPER, AN DEM EIN KOAXIALKABEL POSITIONIERT IST
DISPOSITIF ÉLECTRONIQUE COMPRENANT UN CORPS DE SUPPORT AU NIVEAU DUQUEL UN CÂBLE COAXIAL EST POSITIONNÉ

(30) Priority: 17.02.2022 KR 20220020612; 24.02.2022 KR 20220024042
(43) Date of publication of application: 23.10.2024
(73) Proprietor: Samsung Electronics Co., Ltd., Suwon-si, Gyeonggi-do 16677 (KR)
(72) Inventor: KIM, Sanguk, Suwon-si Gyeonggi-do 16677 (KR); KIM, Youngchul, Suwon-si Gyeonggi-do 16677 (KR); KIM, Youngwoong, Suwon-si Gyeonggi-do 16677 (KR); MOON, Miryeong, Suwon-si Gyeonggi-do 16677 (KR); KU, Doil, Suwon-si Gyeonggi-do 16677 (KR); PARK, Younghak, Suwon-si Gyeonggi-do 16677 (KR)
(74) Representative: Arnold & Siedsma
(86) International application number: PCT/KR2022/020826
(87) International publication number: WO 2023/158087

(56) References cited:
- JP-A- 2016 091 899
- JP-A- 2016 091 899
- JP-A- 2017 224 786
- JP-A- H0 521 968
- KR-A- 20130 087 731
- KR-A- 20170 066 990
- US-B2- 8 576 569

## Description

The disclosure relates to an electronic device including a support body on which a coaxial cable is positioned.

A coaxial cable having excellent linearity and a decent damping ratio for a signal that is less than or equal to approximately 6 GHz has been used to connect electronic components in an electronic device. A clearance between a signal line and a ground line enclosing the signal line of a coaxial cable may need to be guaranteed to achieve the desired performance of the coaxial cable. The above description is information the inventor(s) acquired during the course of conceiving the present disclosure or already possessed at the time and is not necessarily art publicly known before the present application was filed.

US 8 576 569 B2 relates to retention structures are provided to guide and secure a co-axial cable from an upper portion to a lower portion of a logic board having a bend region. In one embodiment, a retention structure can guide, retain, and electrically ground the co-axial cable at multiple locations. In another embodiment, a retention structure can provide route a co-axial cable around the bend region of the logic board, while providing strain relief and the ability to accommodate co-axial cables of different lengths, due to manufacturing tolerances. Multi-purpose cowling structures are also provided to minimize spacing impact within an electronic device, while maximizing functional utility. In another embodiment, a cowling can electrically connect the ground plane of a logic board to the ground plane of a housing member and provide a pre-load force to a conductor connection existing on logic board

JP 2016 091899 A relates to a jacket barrel part or a shield barrel part comprising an elastic contact plate which is brought into elastic contact with a conducting path of the electrical equipment and since electrical connections are performed by elastic displacement of the elastic contact plate itself, in fitting cable clamps, a soldering step or an adhesion step in the prior arts is omitted and the cable clamps are directly electrically connected without interposing a wiring board. By elastically displacing the elastic contact plates again while reducing the number of components or the number of steps, the cable clamps can be removed.

According to an example embodiment, an electronic device includes: a first printed circuit board (PCB), a second PCB, a connecting assembly including a first coaxial cable connecting the first PCB to the second PCB and a clamp configured to clamp the first coaxial cable, and a support body including a groove configured to accommodate the first coaxial cable therein, wherein the groove includes a first path portion and a second path portion on which the clamp is positioned, the first path portion includes a first side surface, a second side surface opposite to the first side surface, and a first bottom surface between the first side surface and the second side surface, the second path portion includes a third side surface, a fourth side surface opposite to the third side surface, and a second bottom surface between the third side surface and the fourth side surface, wherein the second path portion includes a protruding rib protruding toward the fourth side surface from the third side surface and to which the clamp is grounded, and a recessed formed on the fourth side surface.

According to an example embodiment, an electronic device includes: a first PCB, a second PCB, a connecting assembly including a first coaxial cable connecting the first PCB to the second PCB and a clamp configured to clamp the first coaxial cable, and a groove configured to accommodate the first coaxial cable therein, wherein the groove includes a first path portion on which the clamp is not positioned and a second path portion on which the clamp is positioned, the first path portion includes a first side surface, a second side surface opposite to the first side surface, and a first bottom surface between the first side surface and the second side surface, the second path portion includes a third side surface, a fourth side surface opposite to the third side surface, and a second bottom surface between the third side surface and the fourth side surface, wherein the second path portion further includes a plurality of first protrusions arranged on one side surface of the third side surface and the fourth side surface.

According to an example embodiment, an electronic device includes: a first PCB, a second PCB, a connecting assembly including a first coaxial cable connecting the first PCB to the second PCB and a clamp configured to clamp the first coaxial cable, a support body including a groove configured to accommodate the first coaxial cable therein, wherein the groove includes a first path portion on which the clamp is not positioned and a second path portion on which the clamp is positioned, the first path portion includes a first side surface, a second side surface opposite to the first side surface, and a first bottom surface between the first side surface and the second side surface, the second path portion includes a third side surface, a fourth side surface opposite to the third side surface, and a second bottom surface between the third side surface and the fourth side surface, wherein the third side surface is inclined relative to the first side surface, and the fourth side surface is inclined relative to the second side surface.

The foregoing and other aspects, features, and advantages of certain embodiments in the present disclosure will be more apparent from the following detailed description, taken in conjunction with the accompanying drawings, in which:
FIG. 1 is a block diagram illustrating an example electronic device in a network environment according to an embodiment.
FIG. 2A is a perspective view of an electronic device viewed in one direction according to an embodiment.
FIG. 2B is a perspective view of the electronic device viewed in another direction according to an embodiment.
FIG. 2C is an exploded perspective view of an electronic device according to an embodiment.
FIG. 3A is a diagram illustrating a plan view of an internal structure of an electronic device according to an embodiment.
FIG. 3B is a cross-sectional view of a support body and coaxial cables taken along line 3B-3B of FIG. 3A.
FIG. 3C is a diagram illustrating an enlarged view of a portion 3C of FIG. 3A.
FIG. 3D is a diagram illustrating a plan view of a support body according to an embodiment.
FIG. 4 is a diagram illustrating a plan view of a support body according to an embodiment.
FIG. 5 is a diagram illustrating a plan view of a support body according to an embodiment.

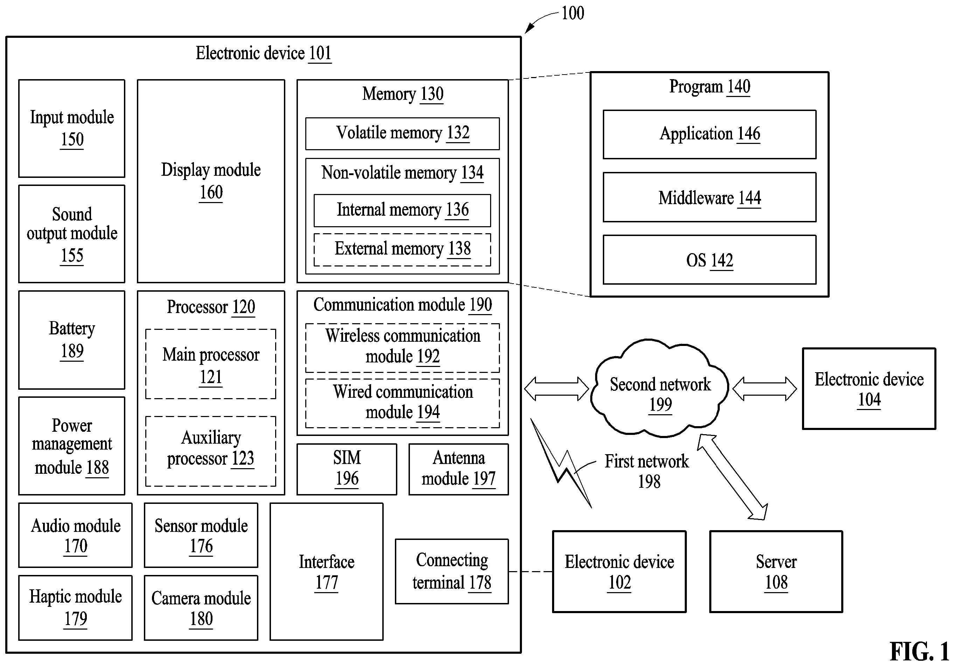

FIG. 1 is a block diagram illustrating an example electronic device in a network environment according to an embodiment.

Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to an embodiment, the display module 160 may include a touch sensor adapted to sense a touch, or a pressure sensor adapted to measure an intensity of a force incurred by the touch.

The audio module 170 may convert a sound into an electrical signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more of the external electronic devices 102, 104, and 108. For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the result, with or without further processing the result, as at least part of a response to the request. To this end, cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or IoT-related technology.

The electronic device according to the embodiments disclosed herein may be one of various types of electronic devices. The electronic device may include, for example, a portable communication device (e.g., a smartphone), a computer device, a portable multimedia device, a portable medical device, a camera, a wearable device, a home appliance device, or the like. According to an embodiment of the present disclosure, the electronic device is not limited to those described above.

It should be appreciated that various embodiments of the present disclosure and the terms used therein are not intended to limit the technological features set forth herein to particular embodiments and include various changes or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., by wire), wirelessly, or via a third element.

As used in connection with embodiments of the disclosure, the term "module" may include a unit implemented in hardware, software, or firmware, or any combination thereof, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least portion of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

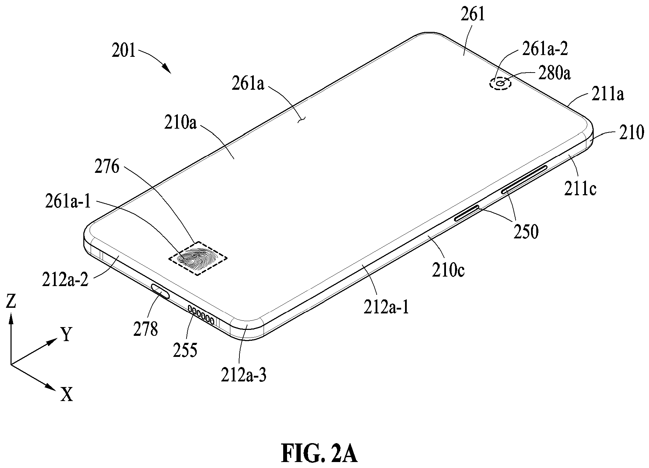

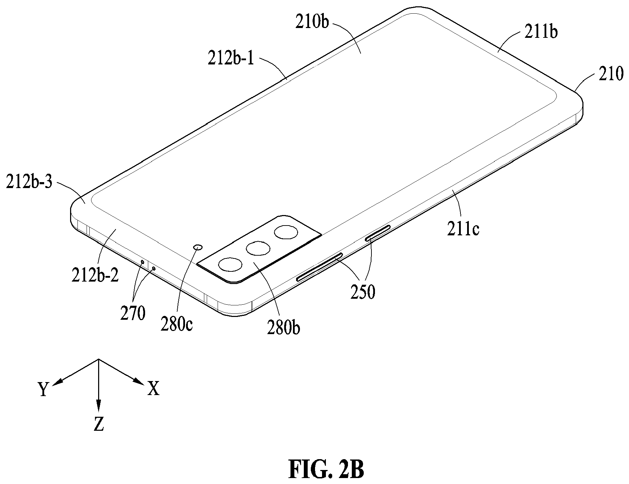

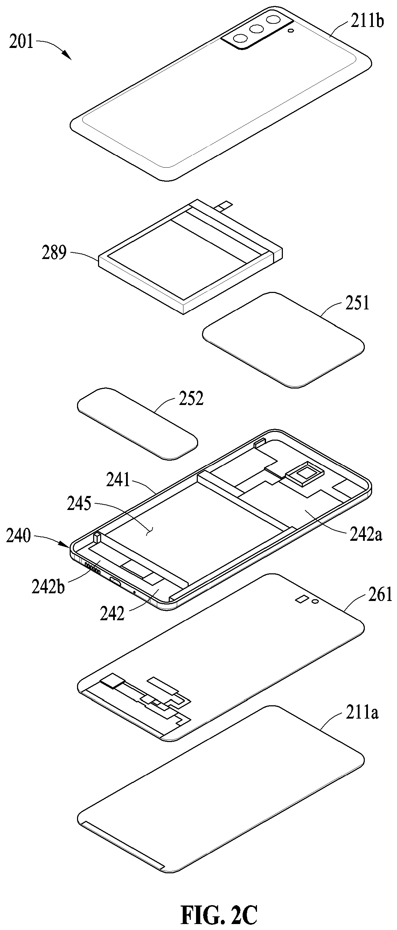

FIG. 2A is a perspective view of an electronic device viewed in one direction according to an embodiment. FIG. 2B is a perspective view of the electronic device viewed in another direction according to an embodiment. FIG. 2C is an exploded perspective view of an electronic device according to an embodiment.

Referring to FIGS. 2A to 2C, an electronic device 201 (e.g., the electronic device 101 of FIG. 1) may include a housing 210 including a first surface 210a (e.g., a front surface), a second surface 210b (e.g., a rear surface), and a third surface 210c (e.g., a side surface) enclosing a space between the first surface 210a and the second surface 210b.

In an embodiment, the first surface 210a may be formed by a first plate 211a of which at least a portion is substantially transparent. For example, the first plate 211a may include a polymer plate or a glass plate including at least one coating layer. The second surface 210b may be formed by a second plate 211b that is substantially opaque. For example, the second plate 211b may be formed of coated or tinted glass, ceramic, polymer, metal (e.g., aluminum, stainless steel (STS), or magnesium), or a combination thereof. The third surface 210c may be formed by a frame 211c that is coupled to the first plate 211a and the second plate 211b and includes a metal and/or a polymer. The second plate 211b and the frame 211c may be integrally and seamlessly formed. The second plate 211b and the frame 211c may be formed of the same material (e.g., aluminum).

In an embodiment, the first plate 211a may include a plurality of first periphery areas 212a-1. The plurality of first periphery areas 212a-1 may face the second plate 211b from at least a partial region of the first surface 210a. The plurality of first periphery areas 212a-1 may be rounded. The plurality of first periphery areas 212a-1 may extend in one direction (e.g., the +/-Y direction). The first plate 211a may include a plurality of second periphery areas 212a-2. The plurality of second periphery areas 212a-2 may face the second plate 211b from at least a partial region of the first surface 210a. The plurality of second periphery areas 212a-2 may be rounded. The plurality of second periphery areas 212a-2 may extend in another direction (e.g., the +/-X direction). The first plate 211a may include a plurality of third periphery areas 212a-3. The plurality of third periphery areas 212a-3 may face the second plate 211b from at least a partial region of the first surface 210a. The plurality of third periphery areas 212a-3 may be rounded. The plurality of third periphery areas 212a-3 may be between the plurality of first periphery areas 212a-1 and the plurality of second periphery areas 212a-2.

In an embodiment, the second plate 211b may include a plurality of fourth periphery areas 212b-1. The plurality of fourth periphery areas 212b-1 may face the first plate 211a from at least a partial region of the second surface 210b. The plurality of fourth periphery areas 212b-1 may be rounded. The plurality of fourth periphery areas 212b-1 may extend in one direction (e.g., the +/-Y direction). The second plate 211b may include a plurality of fifth periphery areas 212b-2. The plurality of fifth periphery areas 212b-2 may face the first plate 211a from at least a partial region of the second surface 210b. The plurality of fifth periphery areas 212b-2 may be rounded. The plurality of fifth periphery areas 212b-2 may extend in another direction (e.g., the +/-X direction). The second plate 211b may include a plurality of sixth periphery areas 212b-3. The plurality of sixth periphery areas 212b-3 may face the first plate 211a from at least a partial region of the second surface 210b. The plurality of sixth periphery areas 212b-3 may be rounded. The plurality of sixth periphery areas 212b-3 may be between the plurality of fourth periphery areas 212b-1 and the plurality of fifth periphery areas 212b-2.

In an embodiment, the electronic device 201 may include a display 261 (e.g., the display module 160 of FIG. 1). The display 261 may be positioned on the first surface 210a. The display 261 may be visible through at least a portion (e.g., the plurality of first periphery areas 212a-1, the plurality of second periphery areas 212a-2, and the plurality of third periphery areas 212a-3) of the first plate 211a. The display 261 may have a shape that is substantially the same as the shape of an outer edge of the first plate 211a. The periphery of the display 261 may substantially coincide with the outer edge of the first plate 211a. The display 261 may include a touch-sensing circuit, a pressure sensor for measuring the intensity (pressure) of a touch, and/or a digitizer for detecting a magnetic-type stylus pen. The display 261 may include a screen display area 261a that is visible to display content using pixels. The screen display area 261a may include a sensing area 261a-1 and/or a camera area 261a-2. The sensing area 261a-1 may overlap at least one area of the screen display area 261a. The sensing area 261a-1 may allow transmission of an input signal related to a sensor module 276 (e.g., the sensor module 176 of FIG. 1). The sensing area 261a-1 may display content, like the screen display area 261a that does not overlap the sensing area 261a-1. For example, the sensing area 261a-1 may display the content while the sensor module 276 is not operating. The camera area 261a-2 may overlap at least one area of the screen display area 261a. The camera area 261a-2 may allow transmission of an optical signal related to a first camera module 280a (e.g., the camera module 180 of FIG. 1). The camera area 261a-2 may display content, like the screen display area 261a that does not overlap the camera area 261a-2. For example, the camera area 261a-2 may display the content while the first camera module 280a is not operating.

In an embodiment, the electronic device 201 may include an audio module 270 (e.g., the audio module 170 of FIG. 1). The audio module 270 may be positioned on the third surface 210C. The audio module 270 may obtain a sound through at least one hole.

In an embodiment, the electronic device 201 may include the sensor module 276. The sensor module 276 may be positioned on the first surface 210a. The sensor module 276 may form the sensing area 261a-1 in at least a portion of the screen display area 261a. The sensor module 276 may receive an input signal transmitted through the sensing area 261a-1 and generate an electrical signal based on the received input signal. In an example, the input signal may have a designated physical quantity (e.g., heat, light, temperature, sound, pressure, or ultrasound). As another example, the input signal may include a signal related to biometric information (e.g., a fingerprint) of a user.

In an embodiment, the electronic device 201 may include the first camera module 280a, a second camera module 280b (e.g., the camera module 180 of FIG. 1), and a flash 280c. The first camera module 280a may be positioned on the first surface 210a. The second camera module 280b and the flash 280c may be positioned on the second surface 210b. At least a portion of the first camera module 280a may be positioned under the display 261. The first camera module 280a may receive an optical signal transmitted through the camera area 261a-2. The second camera module 280b may include a plurality of camera modules (e.g., a dual camera, a triple camera, or a quad camera). The flash 280c may include a light-emitting diode or a xenon lamp.

In an embodiment, the electronic device 201 may include a sound output module 255 (e.g., the sound output module 155). The sound output module 255 may be positioned on the third surface 210c. The sound output module 255 may include one or more holes.

In an embodiment, the electronic device 201 may include an input module 250 (e.g., the input module 150 of FIG. 1). The input module 250 may be positioned on the third surface 210c. The input module 250 may include at least one key input device.

In an embodiment, the electronic device 201 may include a connecting terminal 278 (e.g., the connecting terminal 178 of FIG. 1). The connecting terminal 278 may be positioned on the third surface 210c. For example, when the electronic device 201 is viewed in one direction (e.g., the +Y direction), the connecting terminal 278 may be positioned at a central portion of the third surface 210c, and the sound output module 255 may be positioned on one side (e.g., a right side) with respect to the connecting terminal 278.

In an embodiment, the electronic device 201 may include a support body 240, a first circuit board 251, a second circuit board 252, and a battery 289 (e.g., the battery 189 of FIG. 1). At least a portion of the support body 240 may form the housing 210 together with the first plate 211a and the second plate 211b. The support body 240 may include a frame structure 241 (e.g., the frame 211c) and a plate structure 242. The frame structure 241 may be formed to surround a periphery of the plate structure 242. The frame structure 241 may connect the periphery of the first plate 211a and the periphery of the second plate 211b. The frame structure 241 may enclose a space between the first plate 211a and the second plate 211b. The frame structure 241 may form the third surface 210c of the electronic device 201. The plate structure 242 may include a first portion 242a for accommodating the first circuit board 251 and a second portion 242b for accommodating the second circuit board 252. The display 261 may be positioned on one surface (e.g., a bottom surface) of the plate structure 242, and the first circuit board 251 and the second circuit board 252 may be positioned on the other surface (e.g., a top surface) of the plate structure 242. The plate structure 242 may include an opening 245 positioned between the first portion 242a and the second portion 242b and passing through both surfaces of the plate structure 242. The opening 245 may accommodate the battery 289.

The description provided herein may also apply to electronic devices of various shapes/forms (e.g., a foldable electronic device, a slidable electronic device, a digital camera, a digital video camera, a tablet PC, a laptop computer, and other electronic devices), in addition to the electronic device shown in FIGS. 2A to 2C.

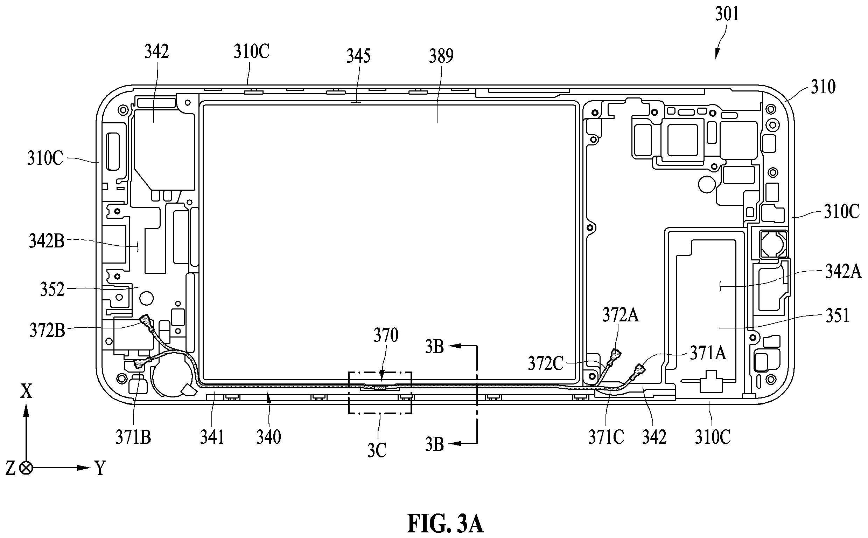

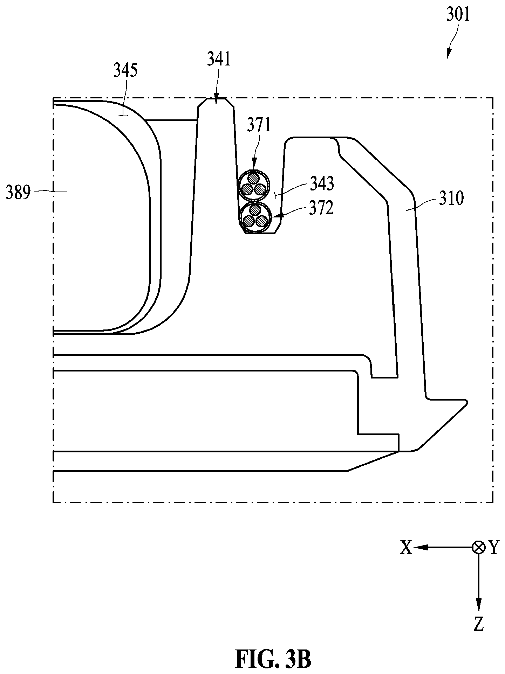

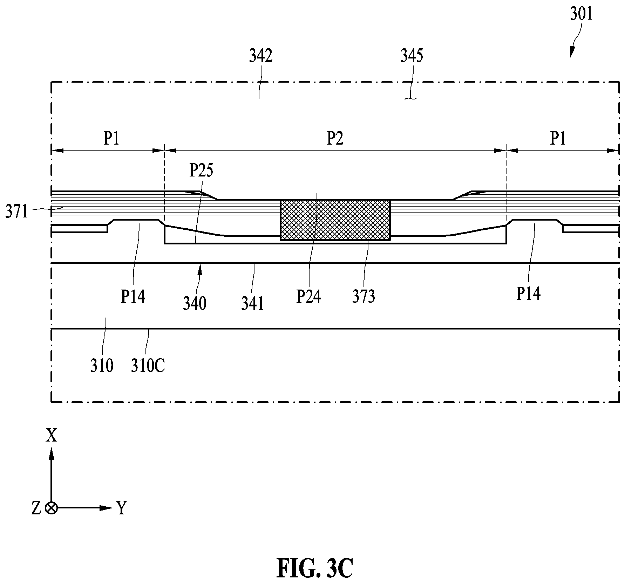

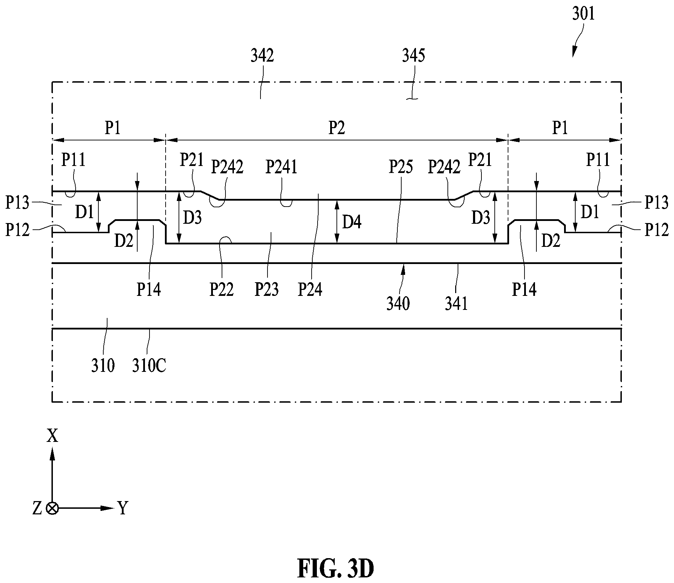

FIG. 3A is a diagram illustrating a plan view of an internal structure of an electronic device according to an embodiment. FIG. 3B is a cross-sectional view of a support body and coaxial cables taken along line 3B-3B of FIG. 3A. FIG. 3C is a diagram illustrating an enlarged view of a portion 3C of FIG. 3A. FIG. 3D is a diagram illustrating a plan view of a support body according to an embodiment.

Referring to FIGS. 3A to 3D, an electronic device 301 (e.g., the electronic device 101 of FIG. 1 and/or the electronic device 201 of FIGS. 2A to 2C) may include a housing 310 (e.g., the housing 210 of FIGS. 2A to 2C) including a first surface (e.g., the first surface 210a of FIGS. 2A to 2C), a second surface (e.g., the second surface 210b of FIGS. 2A to 2C), and a plurality of side surfaces 310C (e.g., the third surface 210c of FIGS. 2A to 2C).

In an embodiment, the electronic device 301 may include a support body 340 (e.g., the support body 240 of FIGS. 2A to 2C) disposed inside the housing 310. The support body 340 may include a frame structure 341 (e.g., the frame structure 241 of FIGS. 2A to 2C) and a plate structure 342 (e.g., the plate structure 242 of FIGS. 2A to 2C).

In an embodiment, the frame structure 341 may include a groove 343 configured to accommodate at least one component (e.g., coaxial cables 371 and 372) therein. The groove 343 may be formed on an edge area of the frame structure 341 in a longitudinal direction (e.g., the +/-Y direction) along one surface 310C of the plurality of side surfaces 310C of the housing 310.

In an embodiment, the groove 343 may have a substantially constant width (e.g., the size in the +/-X direction) in a depth direction (e.g., the +/-Z direction) of the groove 343. The groove 343 may have a width that gradually decreases in the depth direction (e.g., the +/-Z direction) of the groove 343.

In an embodiment, the groove 343 may include a plurality of path portions P1 and P2 passing through at least one component (e.g., the coaxial cables 371 and 372) in different directions. For example, the groove 343 may include the first path portion P1 having a determined path and the second path portion P2 positioned on the first path portion P1 and having a modified path that is different from the path of the first path portion P1. The coaxial cables 371 and 372 may proceed along the path of the first path portion P1 and may proceed along the modified path in the second path portion P2.

In an embodiment, the first path portion P1 may include a first side surface P11, a second side surface P12 that is opposite to the first side surface P11, and a first bottom surface P13 between the first side surface P11 and the second side surface P12. The first side surface P11 may be oriented to the side surface 310C (e.g., be oriented in the -X direction) of the housing 310. The second side surface P12 may be oriented to an accommodation part 345 (e.g., be oriented in the +X direction) of the plate structure 342. The second path portion P2 may include a third side surface P21, a fourth side surface P22 that is opposite to the third side surface P21, and a second bottom surface P23 between the third side surface P21 and the fourth side surface P22. The third side surface P21 may be oriented to the side surface 310C (e.g., be oriented in the -X direction) of the housing 310. The fourth side surface P22 may be oriented to the accommodation part 345 (e.g., be oriented in the +X direction) of the plate structure 342.

In an embodiment, the first path portion P1 may include at least one protrusion P14 protruding toward the first side surface P11 from the second side surface P12. For example, a surface of the protrusion P14 facing the first side surface P11 may have an arbitrary surface (e.g., a substantially smooth flat surface) that is suitable for not damaging at least one component (e.g., the coaxial cables 371 and 372) in the first path portion P1.

In an embodiment, the protrusion P14 may be disposed adjacent to the second path portion P2 or immediately before entering the second path portion P2.

In an embodiment, the protrusion P14 may be formed on an entirety of the second side surface P12 in the depth direction (e.g., the +/-Z direction) of the groove 343. The protrusion P14 may be formed on a portion of the second side surface P12 in the depth direction (e.g., the +/-Z direction) of the groove 343. For example, the protrusion P14 may be offset from the first bottom surface P13.

In an embodiment, the second path portion P2 may include a protruding rib P24 protruding toward the fourth side surface P22 from the third side surface P21. The protruding rib P24 may extend in a path direction (e.g., the +/-Y direction) of the second path portion P2 along the third side surface P21. The protruding rib P24 may partially extend along the third side surface P21. The protruding rib P24 may substantially cross an entirety of the third side surface P21.

In an embodiment, the protruding rib P24 may be formed throughout the entirety of the third side surface P21 in the depth direction (e.g., the +/-Z direction) of the groove 343. The protruding rib P24 may be substantially formed on a portion of the third side surface P21 in the depth direction (e.g., the +/-Z direction) of the groove 343. For example, the protruding rib P24 may be offset from the second bottom surface P23.

In an embodiment, the protruding rib P24 may include a substantially flat first rib surface P241 and a pair of second rib surfaces P242 formed on both sides of the first rib surface P241 inclinedly to the first rib surface P241. The pair of second rib surfaces P242 may continue to the third side surface P21 and/or the first side surface P11.

In an embodiment, the second path portion P2 may include a recess P25 recessed in the fourth side surface P22. The recess P25 may secure an arrangement space of at least one component (e.g., the coaxial cables 371 and 372) in the second path portion P2 that may decrease due to the protruding rib P24.

In an embodiment, the recess P25 may extend in a path direction (e.g., the +/-Y direction) of the second path portion P2 along the fourth side surface P22. The recess P25 may be formed throughout an entirety of the fourth side surface P22. The recess P25 may be partially formed on the fourth side surface P22.

In an embodiment, the groove 343 may have different widths (e.g., the size in the +/-X direction) at least some positions throughout the first path portion P1 and the second path portion P2. For example, a distance D1 between the first side surface P11 and the second side surface P12 may be approximately 0.9 mm, a distance D2 between the first side surface P11 and the protrusion P14 may be approximately 0.65 mm, a distance D3 between the third side surface P21 and the fourth side surface P22 (or the recess P25) may be approximately 1.1 mm, and a distance D4 between the protruding rib P24 and the fourth side surface P22 (or the recess P25) may be approximately 1.0 mm.

However, for example, when a path change generated by the third side surface P21 and the fourth side surface P22 (or the recess P25) is able to achieve stable grounding (e.g., grounding between the protruding rib P24 and a clamp 373), the size of the distances described above may be variously determined to have a margin by considering the size of at least one component (e.g., the coaxial cables 371 and 372 and/or the clamp 373).

In an embodiment, the plate structure 342 may include a first portion 342A (e.g., an upper portion or the first portion 242a of FIGS. 2A to 2C), a second portion 342B (e.g., the second portion 242b of FIGS. 2A to 2C) disposed opposite to the first portion 342A, and an accommodation portion 345 (e.g., the opening 245 of FIGS. 2A to 2C) disposed between the first portion 342A and the second portion 342B and configured to accommodate at least a portion of a battery 389 (e.g., the battery 289 of FIGS. 2A to 2C).

In an embodiment, the frame structure 341 and the plate structure 342 may be integrally and seamlessly formed as one. The frame structure 341 and the plate structure 342 may be separate components and may be connected, coupled, or combined with each other in an arbitrary and suitable manner (e.g., double injection).

In an embodiment, at least a portion of the frame structure 341 and the plate structure 342 may be formed of a conductive material (e.g., a metal material). In an embodiment, the groove 343 may be formed of a conductive material (e.g., a metal material).

In an embodiment, the electronic device 301 may include a first PCB 351 (e.g., the first circuit board 251 of FIGS. 2A to 2C) disposed on the first portion 342A of the plate structure 342 and a second PCB 352 (e.g., the second circuit board 252 of FIGS. 2A to 2C) disposed on the second portion 342B of the plate structure 342.

In an embodiment, the electronic device 301 may include a connecting assembly 370 that connects the first PCB 351 to the second PCB 352. The connecting assembly 370 may include at least one of the coaxial cables 371 and 372 configured to transmit a signal between the first PCB 351 and the second PCB 352 and at least one clamp 373 configured to clamp the at least one of coaxial cables 371 and 372 to the support body 340.

In an embodiment, the connecting assembly 370 may include the first coaxial cable 371 configured to transmit a signal in a first frequency band and the second coaxial cable 372 configured to transmit a signal in a second frequency band that is different from the first frequency band. Unlike the shown embodiment, the connecting assembly 370 may include at least three coaxial cables. The connecting assembly 370 may include a single coaxial cable (e.g., the first coaxial cable 371 or the second coaxial cable 372).

In an embodiment, the first coaxial cable 371 may include a first receptacle 371A disposed on the first PCB 351. The first coaxial cable 371 may include a second receptacle 371B disposed on the second PCB 352. The first coaxial cable 371 may include a first extension 371C extending between the first receptacle 371A and the second receptacle 371B. The second coaxial cable 372 may include a third receptacle 372A disposed on the first PCB 351. The second coaxial cable 372 may include a fourth receptacle 372B disposed on the second PCB 352. The second coaxial cable 372 may include a second extension 372 C extending between the third receptacle 372A and the fourth receptacle 372B.

In an embodiment, the first coaxial cable 371 may be positioned on the second coaxial cable 372. For example, at least a portion of the first extension 371C may be positioned on at least a portion of the second extension 372C. In the groove 343, the first coaxial cable 371 may be positioned on the second coaxial cable 372. The first coaxial cable 371 may contact the side surface of the groove 343 and may not contact the bottom surface of the groove 343, whereas the second coaxial cable 372 may contact the side surface and/or the bottom surface of the groove 343.

In an embodiment, the first coaxial cable 371 may be pushed to the first side surface P11 by the first protrusion P1. The first protrusion P1 may not push the second coaxial cable 372. The first protrusion P1 may also push the second coaxial cable 372.

In an embodiment, the clamp 373 may be configured to clamp the first coaxial cable 371 to the groove 343. The first coaxial cable 371 may be grounded to the support body 340 through the clamp 373.

In an embodiment, the second coaxial cable 372 may be grounded to the support body 340 by contacting the side surface and/or the bottom surface of the groove 343 without the clamp 373. In an embodiment that is not shown, the second coaxial cable 372 may be grounded to the support body 340 by an additional clamp by considering a signal transmitted by the second coaxial cable 372, thickness (e.g., a diameter) of the coaxial cable 372, a width (e.g., the size in the +/-X direction) of the groove 343 on which the second coaxial cable 372 is positioned, and/or other parameters.

In an embodiment, the clamp 373 may not be positioned on the first path portion P1 and may be positioned on the second path portion P2. The clamp 373 may also be positioned on the first path portion P1.

In an embodiment, the clamp 373 may be in contact with the protruding rib P24. For example, the grounding of the clamp 373 and the protruding rib P24 may be strengthened due to a path change of the first coaxial cable 371 proceeding the first path portion P1 and the second path portion P2 as the protrusion P14 pushes the first coaxial cable 371.

In an embodiment, the clamp 373 may be positioned to correspond to the protruding rib P24. For example, the clamp 373 may be positioned on a central portion of the protruding rib P24. As another example, the clamp 373 may be positioned on a portion out of the central portion of the protruding rib P24.

In an embodiment, the clamp 373 may be positioned to correspond to the recess P25. For example, the clamp 373 may be positioned on a central portion of the recess P25. As another example, the clamp 373 may be positioned on a portion out of the central portion of the recess P25.

In an embodiment, the clamp 373 may be formed of a conductive material. For example, the clamp 373 may be formed of a metal material.

In an embodiment, the length (e.g., the length in the +/-Y direction) of the clamp 373 may be substantially equal to or less than the length (e.g., an extended length in the +/-Y direction) of the protruding rib P24. As the length of the protruding rib P24 in contact with the clamp 373 is sufficiently secured, the stable grounding between the clamp 373 and the protruding rib P24 may be maintained.

In an embodiment, the clamp 373 may not be in contact with the recess P25. The clamp 373 may have an arbitrary size (e.g., the width in the +/-X direction) that is suitable for contacting both the protruding rib P24 and the recess P25.

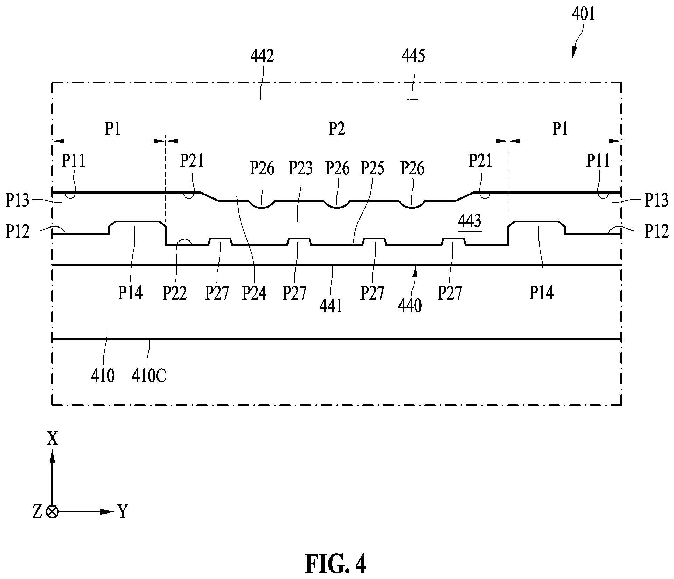

FIG. 4 is a diagram illustrating a plan view of a support body according to an embodiment.

Referring to FIG. 4, an electronic device 401 (e.g., the electronic device 301 of FIGS. 3A to 3D) may include a housing 410 (e.g., the housing 310 of FIGS. 3A to 3D) and a support body 440 (e.g., the support body 340 of FIGS. 3A to 3D). The support body 440 may include a frame structure 441 (e.g., the frame structure 341 of FIGS. 3A to 3D) including a groove 443 (e.g., the groove 343 of FIGS. 3A to 3D) and a plate structure 442 (e.g., the plate structure 342 of FIGS. 3A to 3D) including an accommodation portion 445 (e.g., the accommodation portion 345 of FIGS. 3A to 3D). The groove 443 may include the first path portion P1 and the second path portion P2. The first path portion P1 may include the first side surface P11, the second side surface P12, and the first bottom surface P13. The second path portion P2 may include the third side surface P21, the fourth side surface P22, and the second bottom surface P23.

In an embodiment, the first path portion P1 may include the protrusion P14 (e.g., the protrusion P14 of FIGS. 3C and 3D).

In an embodiment, the second path portion P2 may include the protruding rib P24 (e.g., the protruding rib P24 of FIGS. 3C and 3D). The second path portion P2 may not include the protruding rib P24.

In an embodiment, the second path portion P2 may include the recess P25 (e.g., the recess P25 of FIGS. 3C and 3D). The second path portion P2 may not include the recess P25.

In an embodiment, the second path portion P2 may include at least one first protrusion P26 disposed on the second side surface P21. For example, when positioning a coaxial cable (e.g., the first coaxial cable 371 and/or the second coaxial cable 372 of FIGS. 3A to 3D) on the second path portion P2, the first protrusion P26 may strengthen grounding between the support body 440 (e.g., the third side surface P21 and/or the protruding rib P24) and the coaxial cable and/or a clamp (e.g., the clamp 373 of FIGS. 3A to 3D) without interfering with the positioning of the coaxial cable in the second path portion P2.

In an embodiment, the second path portion P2 may include a plurality of first protrusions P26 arranged on the third side surface P21 and/or the protruding rib P24 in a path direction (e.g., the +/-Y direction) of the second path portion P2.

In an embodiment, the first protrusion P26 may be formed substantially throughout the third side surface P21 and/or the protruding rib P24 in the depth direction (e.g., the +/-Z direction) of the groove 443. The first protrusion P26 may be formed on a portion of the protruding rib P24 and/or the third side surface P21 in the depth direction (e.g., the +/-Z direction) of the groove 443. For example, the first protrusion P26 may be offset from the second bottom surface P23.

In an embodiment, the second path portion P2 may include at least one second protrusion P27 disposed on the fourth side surface P22. For example, when positioning a coaxial cable (e.g., the first coaxial cable 371 and/or the second coaxial cable 372) on the second path portion P2, the second protrusion P27 may strengthen grounding between the support body 440 (e.g., the third side surface P21 and/or the protruding rib P24) and the coaxial cable and/or a clamp (e.g., the clamp 373 of FIGS. 3A to 3D) without interfering with the positioning of the coaxial cable in the second path portion P2.

In an embodiment, the second path portion P2 may include a plurality of second protrusions P27 arranged on the fourth side surface P22 in the path direction (e.g., the +/-Y direction) of the second path portion P2.

In an embodiment, when viewing from the orientation (e.g., the -X direction) of the third side surface P21 and/or the orientation (e.g., the +X direction) of the fourth side surface P22, the second protrusion P27 may be positioned to not overlap the first protrusion P26. The first protrusion P26 and the second protrusion P27 may be positioned to substantially completely overlap or partially overlap each other.

In an embodiment, the second protrusion P27 may be formed substantially throughout the fourth side surface P21 and/or the recess P25 in the depth direction (e.g., the +/-Z direction) of the groove 443. The second protrusion P27 may be formed on a portion of the recess P25 and/or the fourth side surface P21 in the depth direction (e.g., the +/-Z direction) of the groove 443. For example, the second protrusion P27 may be offset from the second bottom surface P23.

In an embodiment, the protruding length and/or the extended length of the first protrusion P26 and/or the second protrusion P27 may be less than the protruding length and/or the extended length of the protrusion P14 of the first path portion P1. The protruding length and/or the extended length of the first protrusion P26 and/or the second protrusion P27 may be substantially equal to or greater than the protruding length and/or the extended length of the protrusion P14 of the first path portion P1.

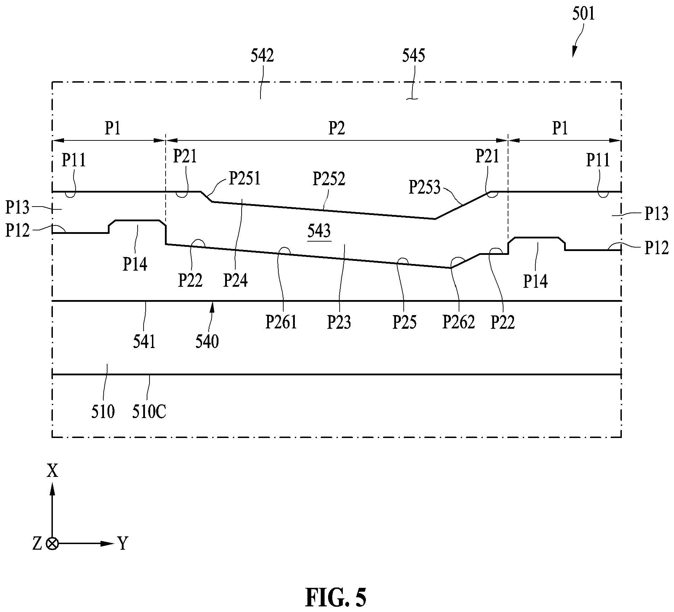

FIG. 5 is a diagram illustrating a plan view of a support body according to an embodiment.

Referring to FIG. 5, an electronic device 501 (e.g., the electronic device 301 of FIGS. 3A to 3D) may include a housing 510 (e.g., the housing 310 of FIGS. 3A to 3D) and a support body 540 (e.g., the support body 340 of FIGS. 3A to 3D). The support body 540 may include a frame structure 541 (e.g., the frame structure 341 of FIGS. 3A to 3D) including a groove 543 (e.g., the groove 343 of FIGS. 3A to 3D) and a plate structure 542 (e.g., the plate structure 342 of FIGS. 3A to 3D) including an accommodation portion 545 (e.g., the accommodation portion 345 of FIGS. 3A to 3D). The groove 543 may include the first path portion P1 and the second path portion P2. The first path portion P1 may include the first side surface P11, the second side surface P12, and the first bottom surface P13. The second path portion P2 may include the third side surface P21, the fourth side surface P22, and the second bottom surface P23.

In an embodiment, the first path portion P1 may include the protrusion P14 (e.g., the protrusion P14 of FIGS. 3C and 3D).

In an embodiment, the second path portion P2 may include the protruding rib P24 (e.g., the protruding rib P24 of FIGS. 3C and 3D). The second path portion P2 may not include the protruding rib P24.

In an embodiment, the second path portion P2 may include the recess P25 (e.g., the recess P25 of FIGS. 3C and 3D). The second path portion P2 may not include the recess P25.

In an embodiment, the third side surface P21 may include at least one of first inclined portions P251, P252, and P253 inclined relative to the first side surface P11. Due to the rigidity and/or conductivity of a coaxial cable (e.g., the first coaxial cable 371 or the second coaxial cable 372 of FIGS. 3A to 3D) and/or a clamp (e.g., the clamp 373 of FIGS. 3A to 3D), grounding between the first inclined portion P251, P252, or P253 and the coaxial cable and/or the clamp may be strengthened. Even when the width between the third side surface P21 and the fourth side surface P22 is substantially equal to or greater than the width of the coaxial cable and/or the clamp, the grounding between the first inclined portion P251, P252, or P253 and the coaxial cable and/or the clamp may be strengthened.

In an embodiment, the first inclined portions P251, P252, P253 may include the first inclined area P251 inclined at a first angle relative to the first side surface P11, a second inclined area P252 connected to the first inclined area P251 and inclined at a second angle that is different from the first angle relative to the first side surface P11, and a third inclined area P253 connected to the second inclined area P252 and inclined at a third angle that is different from the first angle and the second angle relative to the first side surface P11. The first inclined portions P251, P252, and P253 may be formed of at least two of the first inclined area P251, the second inclined area P252, and the third inclined area P253. The first inclined portions P251, P252, and P253 may further include additional inclined areas other than the shown inclined areas.

In an embodiment, the first inclined area P251 and/or the third inclined area P253 may continue to the third side surface P21. The first inclined area P251 and/or the third inclined area P253 may directly continue to the first side surface P11.

In an embodiment, at least one of the first inclined area P251, the second inclined area P252, and the third inclined area P253 may be formed on the protruding rib P24.

In an embodiment, the fourth side surface P22 may include at least one of second inclined portions P261 and P262 inclined relative to the second side surface P12. Due to the rigidity and/or conductivity of a coaxial cable (e.g., the first coaxial cable 371 or the second coaxial cable 372) and/or a clamp (e.g., the clamp 373), grounding between the second inclined portion P261 or P262 and the coaxial cable and/or the clamp may be strengthened. Even when the width between the third side surface P21 and the fourth side surface P22 is substantially equal to or greater than the width of the coaxial cable and/or the clamp, the grounding between the second inclined portion P261 or P262 and the coaxial cable and/or the clamp may be strengthened.

In an embodiment, the second inclined portions P261 and P262 may include the fourth inclined area P261 inclined at a fourth angle relative to the second side surface P12 and the fifth inclined area P262 connected to the fourth inclined area P261 and inclined at a fifth angle that is different from the fourth angle relative to the second side surface P12. The second inclined portions P261 and P262 may further include additional inclined areas other than the shown inclined areas.

In an embodiment, the fourth inclined area P261 and/or the fifth inclined area P262 may continue to the fourth side surface P22. The fourth inclined area P261 and/or the fifth inclined area P262 may directly continue to the second side surface P12.

In an embodiment, at least one of the fourth inclined area P261 and the fifth inclined area P262 may be formed on the recess P25.

An aspect of the present disclosure may provide an electronic device for stably grounding a coaxial cable.

According to an embodiment, the electronic device 301 may further include the first PCB 351. The electronic device 301 may include the second PCB 352. The electronic device 301 may include the connecting assembly 370. The connecting assembly 370 may include the first coaxial cable 371 that connects the first PCB 351 to the second PCB 352. The connecting assembly 370 may include the clamp 373 configured to clamp the first coaxial cable 371. The electronic device 301 may include the support body 340. The support body 340 may include the groove 343 configured to accommodate the first coaxial cable 371. The groove 343 may include the first path portion P1 on which the clamp 373 is not positioned. The groove 343 may include the second path portion P2 on which the clamp 373 is positioned. The first path portion P1 may include the first side surface P11, the second side surface P12 that is opposite to the first side surface P11, and the first bottom surface P13 between the first side surface P11 and the second side surface P12. The second path portion P2 may include the third side surface P21, the fourth side surface P22 that is opposite to the third side surface P21, and the second bottom surface P23 between the third side surface P21 and the fourth side surface P22. The second path portion P2 may include the protruding rib P24, which protrudes toward the fourth side surface P22 from the third side surface P21 and to which the clamp 373 is grounded. The second path portion P2 may include the recess P25 formed on the fourth side surface P22.

In an embodiment, the length of the protruding rib P24 along the third side surface P21 may be substantially equal to or greater than the length of the clamp 373 along the third side surface P21.

In an embodiment, the protruding rib P24 and the recess P25 may be positioned to correspond to the clamp 373.

In an embodiment, the protruding rib P24 may be partially formed along the third side surface P21.

In an embodiment, the recess P25 may be formed throughout the entire fourth side surface P22.

In an embodiment, the distance D4 between the protruding rib P24 and the recess P25 may be substantially equal to or less than the distance D3 between the third side surface P21 and the recess P25.

In an embodiment, the first path portion P1 may further include at least one protrusion P14 protruding toward the first side surface P11 from the second side surface P12 and configured to push the first coaxial cable 371.

In an embodiment, the at least one protrusion P14 may be disposed in an area of the second side surface P12 adjacent to the fourth side surface P22.

In an embodiment, the electronic device 201, 301 may include the housing 310 including the first surface 210a, the second surface 210b that is opposite to the first surface 210a, and the side surfaces 210c, 310C between the first surface 210a and the second surface 210b. The protruding rib P24 and the recess P25 may be formed toward the side surface 210c, 310C of the housing 310.

In an embodiment, the connecting assembly 370 may include the second coaxial cable 372. The second coaxial cable 372 may include the first PCB 351 and the second PCB 352. The second coaxial cable 372 may be configured to transmit a signal in a frequency band that is different from a frequency band of a signal transmitted by the first coaxial cable 371. The second coaxial cable 372 may be configured not to be clamped by the clamp.

In an embodiment, the second coaxial cable 372 may be positioned closer to the first bottom surface P13 and the second bottom surface P23 than the first coaxial cable 371 and may be accommodated in the groove 343.

In an embodiment, the groove 343 may have a width that is substantially constant or decreases in the depth direction toward the first bottom surface P13 and/or the second bottom surface P23.

In an embodiment, the protruding rib P24 and the recess P25 may be at least partially formed on the third side surface P21 and the fourth side surface P22 in the depth direction of the groove 343, respectively.

According to an example embodiment, the electronic device 301, 401 may include a first PCB 351. The electronic device 301, 401 may include a second PCB 352. The electronic device 301, 401 may include a connecting assembly 370. The connecting assembly 370 may include a first coaxial cable 371 connecting the first PCB 351 to the second PCB 352. The connecting assembly 370 may include a clamp 373 configured to clamp the first coaxial cable 371. The electronic device 301, 401 may include a support body 340, 440. The support body 340, 440 may include a groove 343, 443 configured to accommodate the first coaxial cable 371. The groove 343, 443 may include a first path portion P1 on which the clamp 373 is not positioned. The groove 343, 443 may include a second path portion P2 on which the clamp 373 is positioned. The first path portion P1 may include a first side surface P11, a second side surface P12 opposite to the first side surface P11, and a first bottom surface P13 between the first side surface P11 and the second side surface P12. The second path portion P2 may include a third side surface P21, a fourth side surface P22 opposite to the third side surface P21, and a second bottom surface P23 between the third side surface P21 and the fourth side surface P22. The second path portion P2 may further include a plurality of first protrusions P26 arranged on one side surface of the third side surface P21 and the fourth side surface P22.

In an example embodiment, the second path portion P2 may further include a plurality of second protrusions P27 arranged on the other side surface of the third side surface P21 and the fourth side surface P22.

In an example embodiment, the second path portion P2 may include a protruding rib P24 protruding toward the fourth side surface P22 from the third side surface P21 on which the clamp 373 is grounded, and to which the plurality of first protrusions P26 is positioned. The second path portion P2 may include a recess P25 formed on the fourth side surface P22 and on which the plurality of second protrusions P27 is positioned.

In an example embodiment, when viewing in the direction toward the fourth side surface P22 from the third side surface P21, the plurality of first protrusions P26 may be positioned to not overlap the plurality of second protrusions P27.

According to an example embodiment, the electronic device 301, 501 may include the first PCB 351. The electronic device 301, 501 may include the second PCB 352. The electronic device 301, 501 may include the connecting assembly 370. The connecting assembly 370 may include the first coaxial cable 371 connecting the first PCB 351 to the second PCB 352. The connecting assembly 370 may include the clamp 373 configured to clamp the first coaxial cable 371. The electronic device 301, 501 may include the support body 340, 540. The support body 340, 540 may include the groove 343, 543 configured to accommodate the first coaxial cable 371. The groove 343, 543 may include the first path portion **P1 on** which the clamp 373 is not positioned. The groove 343, 543 may include the second path portion P2 on which the clamp 373 is positioned. The first path portion **P1** may include the first side surface P11, the second side surface P12 opposite to the first side surface P11, and the first bottom surface P13 between the first side surface **P11** and the second side surface P12. The second path portion P2 may include the third side surface P21, the fourth side surface P22 opposite to the third side surface P21, and the second bottom surface P23 between the third side surface P21 and the fourth side surface P22. The third side surface P21 may be inclined relative to the first side surface P11. The fourth side surface P22 may be inclined relative to the second side surface P12.

In an example embodiment, the clamp 373 may be configured to be grounded to one side surface of the third side surface P21 and the fourth side surface P22.

In an example embodiment, the distance between the third side surface P21 and the fourth side surface P22 may be substantially equal to or greater than the width of the clamp 373.

According to an embodiment, the stability of grounding of the coaxial cable may be improved. The effects of the electronic device according to embodiments are not limited to the above-mentioned effects, and other unmentioned effects can be clearly understood from the following description by one of ordinary skill in the art.

The embodiments of the present disclosure are intended to be illustrative and not restrictive. Various modifications may be made to the detailed description of the present disclosure including the accompanying scope of claims. Any of the embodiment(s) described herein may be used in combination with any other embodiment(s) described herein.

## Claims

1. An electronic device (301, 401, 501), comprising:
a first printed circuit board, PCB, (351),
a second PCB (352),
a first coaxial cable (371) connecting the first PCB (351) to the second PCB (352),
a clamp (373) configured to clamp the first coaxial cable (371), and
a support body (340) comprising a groove (343) configured to accommodate the first coaxial cable (371) therein,
wherein the groove (343) comprises a first path portion (P1) and a second path portion (P2), wherein, among the first path portion (P1) and the second path portion (P2), the clamp (373) is positioned only on the second path portion (P2),
wherein the first path portion (P1) comprises:
a first side surface (P11),
a second side surface (P12) opposite to the first side surface (P11), and
a first bottom surface (P13) between the first side surface (P11) and the second side surface (P12),
wherein the second path portion (P2) comprises:
a third side surface (P21),
a fourth side surface (P22) opposite to the third side surface (P21), and
a second bottom surface (P23) between the third side surface (P21) and the fourth side surface (P22),
wherein the second path portion (P2) comprises:
a protruding rib (P24) protruding toward the fourth side surface (P22) from the third side surface (P21) and to which the clamp (373) is grounded, and
a recess (P25) formed on the fourth side surface (P22).

2. The electronic device of claim 1, wherein a length of the protruding rib (P24) along the third side surface (P21) is equal to or greater than a length of the clamp (373) along the third side surface (P21).

3. The electronic device of claim 1 or 2, wherein the protruding rib (P24) and the recess (P25) are positioned to correspond to the clamp (373).

4. The electronic device of one of claims 1 to 3, wherein the protruding rib (P24) is partially formed along the third side surface (P21).

5. The electronic device of one of claims 1 to 4, wherein the recess (P25) is formed throughout an entirety of the fourth side surface (P22).

6. The electronic device of one of claims 1 to 5, wherein a distance (D4) between the protruding rib (P24) and the recess (P25) is equal or less than a distance (D3) between the third side surface (P21) and the recess (P25).

7. The electronic device of one of claims 1 to 6, wherein the first path portion (P1) further comprises at least one protrusion (P14) configured to push the first coaxial cable (371) and the at least one protrusion (P14) protrudes from the second side surface (P12) toward the first side surface (P11), and wherein the at least one protrusion (P14) is optionally positioned in an area of the second side surface (P12) adjacent to the fourth side surface (P22).

8. The electronic device of one of claims 1 to 7, further comprising a housing (310), wherein the housing (310) comprises:
a first surface (210a),
a second surface (210b) opposite to the first surface (210a), and
a side surface (210c, 310C) between the first surface (210a) and the second surface (210b),
wherein the protruding rib (P24) and the recess (P25) is formed toward the side surface (210c, 310C) of the housing (310).

9. The electronic device of one of claims 1 to 8, further comprising a second coaxial cable (372) connecting the first PCB (351) to the second PCB (352), wherein the second coaxial cable (372) is configured to transmit a signal in a frequency band different from a frequency band of a signal transmitted by the first coaxial cable (371), and wherein, among the first coaxial cable (371) and the second coaxial cable (372), the clamp (373) is configured to only clamp the first coaxial cable (371),
wherein the second coaxial cable (372) is optionally positioned closer to the first bottom surface (P13) and the second bottom surface (P23) than the first coaxial cable (371) and/or is accommodated in the groove (343),
wherein the groove (343) optionally has a constant width or a width that decreases in a depth direction toward the first bottom surface (P13) and/or the second bottom surface (P23), and/or
wherein the protruding rib (P24) and the recess (P25) are optionally at least partially formed on the third side surface P21 and the fourth side surface P22 in a depth direction of the groove (343), respectively.

10. The electronic device of one of claims 1 to 9, wherein the second path portion (P2) further comprises a plurality of first protrusions (P26) arranged on one side surface of the third side surface (P21) and the fourth side surface (P22).

11. The electronic device of one of claims 1 to 10, wherein the second path portion (P2) further comprises a plurality of second protrusions (P27) arranged on the other side surface of the third side surface (P21) and the fourth side surface (P22).

12. The electronic device of one of claims 1 to 11, wherein the plurality of first protrusions (P26) is positioned on the protruding rib (P24) and the plurality of second protrusions (P27) is positioned on the recess (P25).

13. The electronic device of one of claims 1 to 12, wherein the plurality of first protrusions (P26) are positioned in a spaced apart manner relative to the plurality of second protrusions (P27) when viewing in a direction toward the fourth side surface (P22) from the third side surface (P21).

14. The electronic device of one of claims 1 to 13, wherein the third side surface (P21) is inclined relative to the first side surface (P11), and wherein the fourth side surface (P22) is inclined relative to the second side surface (P12).

15. The electronic device of one of claims 1 to 14, wherein the clamp (373) is configured to be grounded to at least one side surface of the third side surface (P21) and the fourth side surface (P22), and/or wherein a distance between the third side surface (P21) and the fourth side surface (P22) is equal to or greater than a width of the clamp (373).

## Patentansprüche

1. Elektronische Vorrichtung (301, 401, 501), die Folgendes umfasst:
eine erste Leiterplatte (PCB, Printed Circuit Board) (351);
eine zweite PCB (352),
ein erstes Koaxialkabel (371), das die erste PCB (351) mit der zweiten PCB (352) verbindet;
eine Klemme (373), die so konfiguriert ist, dass sie das erste Koaxialkabel (371) festklemmt, und
einen Stützkörper (340), der eine Nut (343) umfasst, die so konfiguriert ist, dass sie das erste Koaxialkabel (371) darin aufnimmt,
wobei die Nut (343) einen ersten Pfadabschnitt (P1) und einen zweiten Pfadabschnitt (P2) umfasst,
wobei unter dem ersten Pfadabschnitt (P1) und dem zweiten Pfadabschnitt (P2) die Klemme (373) nur an dem zweiten Pfadabschnitt (P2) positioniert ist,
wobei der erste Pfadabschnitt (P1) Folgendes umfasst:
eine erste seitliche Oberfläche (P11),
eine zweite seitliche Oberfläche (P12), die der ersten seitlichen Oberfläche (P11) gegenüberliegt, und
eine erste Bodenfläche (P13) zwischen der ersten seitlichen Oberfläche (P11) und der zweiten seitlichen Oberfläche (P12),
wobei der zweite Pfadabschnitt (P2) Folgendes umfasst:
eine dritte seitliche Oberfläche (P21),
eine vierte seitliche Oberfläche (P22), die der dritten seitlichen Oberfläche (P21) gegenüberliegt, und
eine zweite Bodenfläche (P23) zwischen der dritten seitlichen Oberfläche (P21) und der vierten seitlichen Oberfläche (P22),
wobei der zweite Pfadabschnitt (P2) Folgendes umfasst:
eine vorstehende Rippe (P24), die von der dritten seitlichen Oberfläche (P21) in Richtung der vierten seitlichen Oberfläche (P22) vorsteht und an der die Klemme (373) geerdet ist, und
eine Ausnehmung (P25), die an der vierten seitlichen Oberfläche (P22) gebildet ist.

2. Elektronische Vorrichtung nach Anspruch 1, wobei eine Länge der vorstehenden Rippe (P24) entlang der dritten seitlichen Oberfläche (P21) größer oder gleich einer Länge der Klemme (373) entlang der dritten seitlichen Oberfläche (P21) ist.

3. Elektronische Vorrichtung nach Anspruch 1 oder 2, wobei die vorstehende Rippe (P24) und die Ausnehmung (P25) so positioniert sind, dass sie der Klemme (373) entsprechen.

4. Elektronische Vorrichtung nach einem der Ansprüche 1 bis 3, wobei die vorstehende Rippe (P24) teilweise entlang der dritten seitlichen Oberfläche (P21) gebildet ist.

5. Elektronische Vorrichtung nach einem der Ansprüche 1 bis 4, wobei die Ausnehmung (P25) über die gesamte vierte seitliche Oberfläche (P22) gebildet ist.

6. Elektronische Vorrichtung nach einem der Ansprüche 1 bis 5, wobei ein Abstand (D4) zwischen der vorstehenden Rippe (P24) und der Ausnehmung (P25) kleiner oder gleich einem Abstand (D3) zwischen der dritten seitlichen Oberfläche (P21) und der Ausnehmung (P25) ist.

7. Elektronische Vorrichtung nach einem der Ansprüche 1 bis 6, wobei der erste Pfadabschnitt (P1) ferner mindestens einen Vorsprung (P14) umfasst, der so konfiguriert ist, dass er das erste Koaxialkabel (371) drückt, und der mindestens eine Vorsprung (P14) von der zweiten seitlichen Oberfläche (P12) in Richtung der ersten seitlichen Oberfläche (P11) vorsteht, und wobei der mindestens eine Vorsprung (P14) optional in einem Bereich der zweiten seitlichen Oberfläche (P12) benachbart zu der vierten seitlichen Oberfläche (P22) positioniert ist.

8. Elektronische Vorrichtung nach einem der Ansprüche 1 bis 7, ferner umfassend ein Gehäuse (310), wobei das Gehäuse (310) Folgendes umfasst:
eine erste Oberfläche (210a),
eine zweite Oberfläche (210b), die der ersten seitlichen Oberfläche (210a) gegenüberliegt, und
eine seitliche Oberfläche (210c, 310C) zwischen der ersten Oberfläche (210a) und der zweiten Oberfläche (210b),
wobei die vorstehende Rippe (P24) und die Ausnehmung (P25) in Richtung der seitlichen Oberfläche (210c, 310C) des Gehäuses (310) gebildet sind.

9. Elektronische Vorrichtung nach einem der Ansprüche 1 bis 8, ferner umfassend ein zweites Koaxialkabel (372), das die erste PCB (351) mit der zweiten PCB (352) verbindet, wobei das zweite Koaxialkabel (372) so konfiguriert ist, dass es ein Signal in einem Frequenzband überträgt, das sich von einem Frequenzband eines durch das erste Koaxialkabel (371) übertragenen Signals unterscheidet, und wobei unter dem ersten Koaxialkabel (371) und dem zweiten Koaxialkabel (372) die Klemme (373) so konfiguriert ist, dass sie nur das erste Koaxialkabel (371) festklemmt,
wobei das zweite Koaxialkabel (372) optional näher an der ersten Bodenfläche (P13) und der zweiten Bodenfläche (P23) positioniert ist als das erste Koaxialkabel (371) und/oder in der Nut (343) aufgenommen ist,
wobei die Nut (343) optional eine konstante Breite oder eine Breite aufweist, die in einer Tiefenrichtung in Richtung der ersten Bodenfläche (P13) und/oder der zweiten Bodenfläche (P23) abnimmt, und/oder
wobei die vorstehende Rippe (P24) und die Ausnehmung (P25) optional mindestens teilweise an der dritten seitlichen Oberfläche (P21) bzw. der vierten seitlichen Oberfläche (P22) in einer Tiefenrichtung der Nut (343) gebildet sind.

10. Elektronische Vorrichtung nach einem der Ansprüche 1 bis 9, wobei der zweite Pfadabschnitt (P2) ferner eine Vielzahl von ersten Vorsprüngen (P26) umfasst, die an einer seitlichen Oberfläche aus der dritten seitlichen Oberfläche (P21) und der vierten seitlichen Oberfläche (P22) angeordnet sind.

11. Elektronische Vorrichtung nach einem der Ansprüche 1 bis 10, wobei der zweite Pfadabschnitt (P2) ferner eine Vielzahl von zweiten Vorsprüngen (P27) umfasst, die an der anderen seitlichen Oberfläche aus der dritten seitlichen Oberfläche (P21) und der vierten seitlichen Oberfläche (P22) angeordnet sind.

12. Elektronische Vorrichtung nach einem der Ansprüche 1 bis 11, wobei die Vielzahl von ersten Vorsprüngen (P26) an der vorstehenden Rippe (P24) positioniert ist und die Vielzahl von zweiten Vorsprüngen (P27) an der Ausnehmung (P25) positioniert ist.

13. Elektronische Vorrichtung nach einem der Ansprüche 1 bis 12, wobei die Vielzahl von ersten Vorsprüngen (P26) relativ zu der Vielzahl von zweiten Vorsprüngen (P27) bei Betrachtung in Richtung der vierten seitlichen Oberfläche (P22) von der dritten seitlichen Oberfläche (P21) aus in einem Abstand voneinander positioniert sind.

14. Elektronische Vorrichtung nach einem der Ansprüche 1 bis 13, wobei die dritte seitliche Oberfläche (P21) relativ zu der ersten seitlichen Oberfläche (P11) geneigt ist und wobei die vierte seitliche Oberfläche (P22) relativ zu der zweiten seitlichen Oberfläche (P12) geneigt ist.

15. Elektronische Vorrichtung nach einem der Ansprüche 1 bis 14, wobei die Klemme (373) so konfiguriert ist, dass sie an mindestens einer seitlichen Oberfläche aus der dritten seitlichen Oberfläche (P21) und der vierten seitlichen Oberfläche (P22) geerdet ist, und/oder wobei ein Abstand zwischen der dritten seitlichen Oberfläche (P21) und der vierten seitlichen Oberfläche (P22) größer oder gleich einer Breite der Klemme (373) ist.

## Revendications

1. Appareil électronique (301, 401, 501), comprenant :
une première carte de circuit imprimé (PCB, printed circuit board) (351),
une deuxième PCB (352),
un premier câble coaxial (371) reliant la première PCB (351) à la deuxième PCB (352),
un dispositif de serrage (373) conçu pour serrer le premier câble coaxial (371), et
un corps de support (340) comprenant une rainure (343) conçue pour recevoir en son intérieur le premier câble coaxial (371) ;
ladite rainure (343) comprenant une première portion de chemin (P1) et une deuxième portion de chemin (P2) concernant lesquelles, parmi la première portion de chemin (P1) et la deuxième portion de chemin (P2), le dispositif de serrage (373) est positionné uniquement sur la deuxième portion de chemin (P2),
ladite première portion de chemin (P1) comprenant :
une première surface latérale (P11),
une deuxième surface latérale (P12) opposée à la première surface latérale (P11), et
une première surface inférieure (P13) entre la première surface latérale (P11) et la deuxième surface latérale (P12) ;
ladite deuxième portion de chemin (P2) comprenant :
une troisième surface latérale (P21),
une quatrième surface latérale (P22) opposée à la troisième surface latérale (P21), et
une deuxième surface inférieure (P23) entre la troisième surface latérale (P21) et la quatrième surface latérale (P22) ;
ladite deuxième portion de chemin (P2) comprenant :
une nervure saillante (P24) faisant saillie vers la quatrième surface latérale (P22) à partir de la troisième surface latérale (P21) et au niveau de laquelle le dispositif de serrage (373) est mis à la terre, et
un évidement (P25) formé sur la quatrième surface latérale (P22).

2. Appareil électronique selon la revendication 1, dans lequel la longueur de la nervure saillante (P24) le long de la troisième surface latérale (P21) est supérieure ou égale à la longueur du dispositif de serrage (373) le long de la troisième surface latérale (P21).

3. Appareil électronique selon la revendication 1 ou 2, dans lequel la nervure saillante (P24) et l'évidement (P25) sont positionnés de manière à correspondre au dispositif de serrage (373).

4. Appareil électronique selon l'une des revendications 1 à 3, dans lequel la nervure saillante (P24) est partiellement formée le long de la troisième surface latérale (P21).

5. Appareil électronique selon l'une des revendications 1 à 4, dans lequel l'évidement (P25) est formé sur la totalité de la quatrième surface latérale (P22).

6. Appareil électronique selon l'une des revendications 1 à 5, dans lequel une distance (D4) entre la nervure saillante (P24) et l'évidement (P25) est inférieure ou égale à une distance (D3) entre la troisième surface latérale (P21) et l'évidement (P25).

7. Appareil électronique selon l'une des revendications 1 à 6, dans lequel la première portion de chemin (P1) comprend en outre au moins une protubérance (P14) conçue pour pousser le premier câble coaxial (371), et l'au moins une protubérance (P14) fait saillie de la deuxième surface latérale (P12) vers la première surface latérale (P11), et dans lequel l'au moins une protubérance (P14) est éventuellement positionnée dans une zone de la deuxième surface latérale (P12) qui est adjacente à la quatrième surface latérale (P22).

8. Appareil électronique selon l'une des revendications 1 à 7, comprenant en outre un boîtier (310), ledit boîtier (310) comprenant :
une première surface (210a),
une deuxième surface (210b) opposée à la première surface (210a), et
une surface latérale (210c, 310C) entre la première surface (210a) et la deuxième surface (210b) ;
ladite nervure saillante (P24) et ledit évidement (P25) étant formés vers la surface latérale (210c, 310C) du boîtier (310).

9. Appareil électronique selon l'une des revendications 1 à 8, comprenant en outre un deuxième câble coaxial (372) reliant la première PCB (351) à la deuxième PCB (352), ledit deuxième câble coaxial (372) étant conçu pour transmettre un signal dans une bande de fréquence différente de celle d'un signal transmis par le premier câble coaxial (371), et, parmi le premier câble coaxial (371) et le deuxième câble coaxial (372), le dispositif de serrage (373) étant conçu pour ne serrer que le premier câble coaxial (371),
ledit deuxième câble coaxial (372) étant éventuellement positionné plus près de la première surface inférieure (P13) et de la deuxième surface inférieure (P23) que le premier câble coaxial (371) et/ou étant reçu dans la rainure (343),
ladite rainure (343) présentant éventuellement une largeur constante ou une largeur qui diminue dans le sens de la profondeur vers la première surface inférieure (P13) et/ou la deuxième surface inférieure (P23), et/ou
ladite nervure saillante (P24) et ledit évidement (P25) étant éventuellement formés au moins partiellement respectivement sur la troisième surface latérale (P21) et la quatrième surface latérale (P22) dans le sens de la profondeur de la rainure (343).

10. Appareil électronique selon l'une des revendications 1 à 9, dans lequel la deuxième portion de chemin (P2) comprend en outre une pluralité de premières protubérances (P26) agencées sur une surface latérale parmi la troisième surface latérale (P21) et la quatrième surface latérale (P22).

11. Appareil électronique selon l'une des revendications 1 à 10, dans lequel la deuxième portion de chemin (P2) comprend en outre une pluralité de deuxièmes protubérances (P27) agencées sur l'autre surface latérale parmi la troisième surface latérale (P21) et la quatrième surface latérale (P22).

12. Appareil électronique selon l'une des revendications 1 à **11,** dans lequel la pluralité de premières protubérances (P26) est positionnée sur la nervure saillante (P24) et la pluralité de deuxièmes protubérances (P27) est positionnée sur l'évidement (P25).

13. Appareil électronique selon l'une des revendications 1 à 12, dans lequel la pluralité de premières protubérances (P26) sont positionnées de manière espacée par rapport à la pluralité de deuxièmes protubérances (P27), vues en direction de la quatrième surface latérale (P22) à partir de la troisième surface latérale (P21).

14. Appareil électronique selon l'une des revendications 1 à 13, dans lequel la troisième surface latérale (P21) est inclinée par rapport à la première surface latérale (P11), et la quatrième surface latérale (P22) est inclinée par rapport à la deuxième surface latérale (P12).

15. Appareil électronique selon l'une des revendications 1 à 14, dans lequel le dispositif de serrage (373) est conçu pour être mis à la terre au niveau d'au moins une surface latérale parmi la troisième surface latérale (P21) et la quatrième surface latérale (P22), et/ou dans lequel la distance entre la troisième surface latérale (P21) et la quatrième surface latérale (P22) est supérieure ou égale à la largeur du dispositif de serrage (373).
